# EUROPEAN PATENT APPLICATION

(11) **EP 1 355 443 A1**
(43) Date of publication of application: **22.10.2003**
(21) Application number: 02017335.7
(22) Date of filing: 02.08.2002
(51) Int. Cl.: H04L 7/033, G01R 31/317, G01R 19/25

(54) **Oversampling bit stream recovery**

(71) Applicant: Agilent Technologies Inc. a Delaware Corporation, Palo Alto, CA 94306 (US)
(72) Inventor: Rivoir, Jochen, 71106 Magstadt (DE)
(74) Representative: Barth, Daniel

(57) **Abstract**

The present invention relates to a method for recovering a bit stream from a signal (12), comprising the steps of receiving said signal (12) as a received bit stream of known first bit rate, over-sampling said received signal (12) with a second bit rate, said second bit rate being n times higher than the first bit rate with n being at least three, said over-sampling resulting in an over-sampled bit stream wherein n bit segments (A,B,C,D) following each other forming a bit segment frame (24,26,28) and representing one bit of said received bit stream respectively, detecting signal transitions (T) in said over-sampled bit stream, identifying first bit segments of said over-sampled bit stream in which no signal transitions (T) occur, selecting one of said first bit segments of each bit segment frame (24,26,28) respectively, extracting bit values from said selected first bit segments, and stringing together said extracted bit values as being said recovered bit stream

## Description

### BACKGROUND OF THE INVENTION

The present invention relates to the recovery of a bit stream.

For testing electronic devices, in particular integrated electronic circuits providing digital electrical output signals, a test or stimulus signal is fed to an input of the device under test, in the following abbreviated as DUT, and a response signal of the DUT is evaluated by an automatic test equipment, in the following abbreviated as ATE, for example by comparison with expected data.

The output timing of modern high-speed electronic devices, particularly integrated electronic circuits, is becoming less and less tightly coupled to a central device clock. During production test of those chips, test equipment has the difficulty of not knowing the exact arrival time of device output signals accurately enough to check the bit level response at the right time. When the device output arrival time is not known exactly or not even stable during the duration of a test, the ATE does not know where to place strobe time points for comparison against expected data.

The reasons for unknown and non-deterministic output timing are beyond others process variations causing unknown but static timing variations, temperature variations of the clock insertion delays causing unknown and time varying timing drift, and jitter causing unknown and non-deterministic timing variations.

### SUMMARY OF THE INVENTION

It is an object of the invention to provide an improved recovery of a bit stream. The object is solved as defined by the independent claims. Preferred embodiments are defined by the dependent claims.

Preferred embodiments of the present invention improve recovering of a bit stream from an output signal of an electronic device under test (DUT), allowing a more reliable evaluation of the performance of the DUT.

According to preferred embodiments of the present invention, the ATE tolerates uncertainties in signal arrival times without even knowing those output arrival times and still being able to perform a dependable bit-level test.

According to preferred embodiments of the present invention, a robust bit level test of DUT output signals in the presence of unknown and/or non-deterministic DUT output timing is enabled.

Prior art production ATE uses fix pre-computed strobe times for comparison against the expected data response. According to preferred embodiments of the present invention, it is avoided that good devices may fail the test and may be rejected just because the exact output timing was not known, even though this may not be a specified parameter. Prior art edge strobe search is conducted for finding the correct strobe time point. According to preferred embodiments of the present invention, time consuming searching can be avoided, especially if the search has to be done for many device output pins. According to preferred embodiments of the present invention, also timing drift during the duration of a test can be tolerated.

According to preferred embodiments of the present invention, a bit extraction and phase tracking scheme can be used, which is based on over-sampling of the DUT output signal. The over-sampled information is shifted into a history shift register, where the rough locations of transitions in the DUT output signal are determined and then used to select a extraction point, which is safely located between transitions. The result is a safely extracted or recovered bit stream, running at a fix clock frequency, which is now free of timing variations.

According to preferred embodiments of the present invention, recovery of bit stream includes and preferably has to be understood as to put the received bit stream into a given phase relation to a known clock that allows reliable evaluation of the recovered bit stream by comparison with expected data.

This bit extraction and phase tracking scheme exploits the fact that the average DUT output frequency or bit rate is exactly known during production test because all clock inputs are generated by the ATE, and thus no clock-data-recovery (CDR) has to extract both frequency and phase.

CDR schemes, which are widely used in the industry, have the task to recover both frequency and phase which is not necessary in a production test environment, where the average frequency of any DUT output signal is exactly known, because all stimuli are provided and therefore known by the ATE, and accordingly DUT can generate only multiples or sub-multiples of those frequencies. Preferred embodiments of the present invention use this knowledge to eliminate the need for an adjustable frequency source, which is a critical analog part. Only a phase recovery needs to be done. Therefore the architecture of the present invention is completely different.

Usual CDR circuits include at least a phase detector, a loop filter and an adjustable frequency source. None of these elements are needed according to preferred embodiments of the present invention which have multiple advantages: The present invention can be applied to any signal, even to such with no clock embedded and independent of any clocking schema. When signal transitions are missing the present invention keeps lock perfectly and lock is performed immediately. A constant time reference can be used. There is no need to align the ATE over-sampling clock to the DUT output signal. Even a precise over-sampling clock is not necessary for the ATE. There is no constraint for a minimum frequency. The signal processing is fully digital and can easily be integrated. If necessary, further features can be added. The implementation effort is only medium and requires mainly over-sampling.

The DUT output signal is over-sampled 3 or more times per bit with a clock from the test equipment. Sampling is either done with one fast clock, which is exactly 3 or more times faster than the output signal or with multiple (3 or more) phase shifted versions of a single clock, which has exactly the frequency of the DUT output signal. Alternatively both edges of a clock with half the frequency can be used. The phase of the sample clocks is arbitrary but fix.

The over-sampled information is shifted into a history shift register that keeps at least temporarily several bits. The transition detection determines in which of the bit segments of the over-sampled bit stream signal transitions actually occur. A phase correction and phase counter keep a multiplexer (MUX) tap point safely between signal transitions in order to extract valid bit information.

According to a preferred embodiment, the invention is partly or entirely implemented in hardware. The invention can alternatively or in addition be partly or entirely embodied or supported by one or more suitable software programs, which can be stored on or otherwise provided by any kind of data carrier, and which might be executed in or by any suitable data processing unit. Software programs or routines are preferably applied in the ATE which can be realized by hardware and/or software alone or by a combination of hardware and software.

### BRIEF DESCRIPTION OF THE DRAWINGS

Other objects and many of the attendant advantages of the present invention will be readily appreciated and become better understood by reference to the following detailed description when considering in connection with the accompanied drawings. Features that are substantially or functionally equal or similar will be referred to with the same reference signs.
Fig. 1 shows a system for recovering a bit stream from an output signal of an electronic device under test (DUT) according to the present invention,
Fig. 2 shows the output signal from the DUT,
Fig. 3 shows a summary of occurrence of signal transitions in bit segments.

### DETAILED DESCRIPTION OF EMBODIMENTS OF THE INVENTION

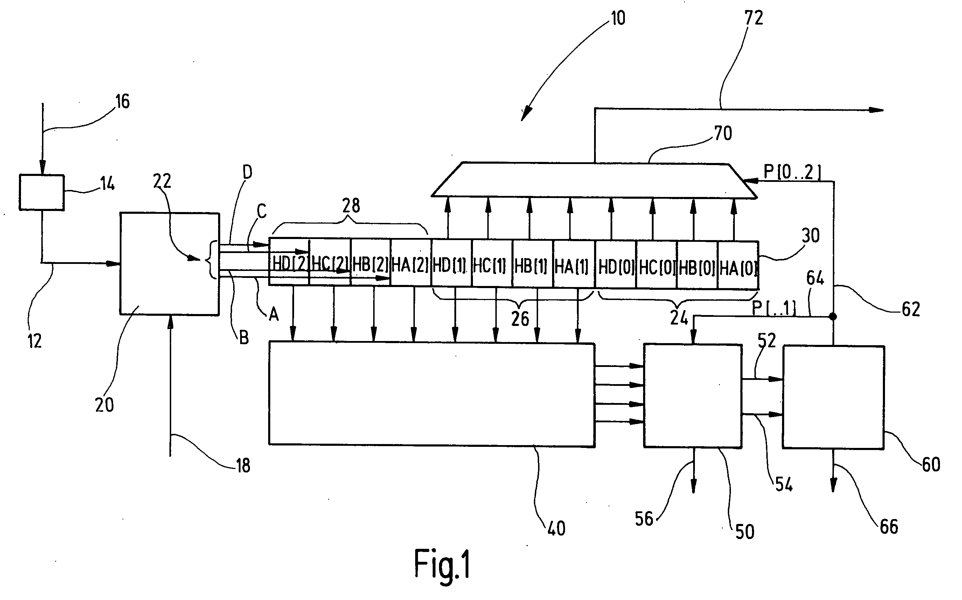

Fig. 1 shows a system 10 for recovering a bit stream from an output signal 12 of an electronic device under test (DUT) 14. The output signal 12 is a first bits stream with a first bit rate in response to a stimulus or test signal 16 fed to the device under test 14. A four phase clock 18 at bit frequency is fed to an over-sampling unit 20 which provides an over-sampled bit stream 22 wherein four bit segments A, B, C, D following each other forming a bit segment frame 24, 26, 28 and representing one bit of said received bit stream of said output signal 12 respectively.

The over-sampled bit stream 22 is temporarily stored in a shift register 30. The over-sampled bit segments HD[2], HC[2],HB[2], HA[2] of a third bit segment frame 28 and the over-sampled bit segments HD[1], HC[1],HB[1], HA[1] of a second bit segment frame 26 are read out into a detecting unit 40 for detecting signal transitions in said over-sampled bit stream 22. First segments of said over-sampled bit stream 22 in which no signal transitions occur are identified by an identifying unit which is in the shown embodiment incorporated by detecting unit 40. Also, second bit segments of said over-sampled bit stream in which signal transitions occur are identified by the identifying unit.

The information of identified bit segments is transmitted via a phase correction unit 50 and a phase tracking counter 60, both explained in more detail below, to a selecting unit 70 for selecting one of said first bit segments of each segment frame 24, 26, 28 respectively. The selecting unit 70 of the shown embodiment also incorporate an extracting unit for extracting bit values from said selected first bit segments and also a data string unit for stringing together said extracted bit values as being said recovered bit stream 72.

The phase tracking counter unit 60 moves the tap point safely between transitions via signal line 62 and provides a feedback to the phase correction unit 50 via signal line 64. The phase tracking counter unit 60 provides to the phase selecting unit 70 the information, the value of which first bit segment P of the first [0] bit segment frame 24, the second [1] bit frame segment 26 and the third [2] bit frame segment 28 has to be extracted. Furthermore, in the state shown in Figure 1, the phase tracking counter unit 60 provides via the signal line 64 the information to the phase correction unit 50, which bit segment P of the first [0] bit segment frame 24 and the second [1] bit segment frame 26 has to be extracted.

The phase tracking counter unit 60 receives an increment signal 52 or a decrement signal 54 from the phase correction unit 50 which detects any phase shift of the bit stream of the output signal 12 by observing the number of the second bit segment in which signal transition occur within bit segment frames following each other. Phase correction unit 50 and phase tracking counter unit 60 both have error outputs 56 and 66 respectively for indicating any error status to a control unit or to external of the ATE, for example an overflow error for phase tracking counter unit 60.

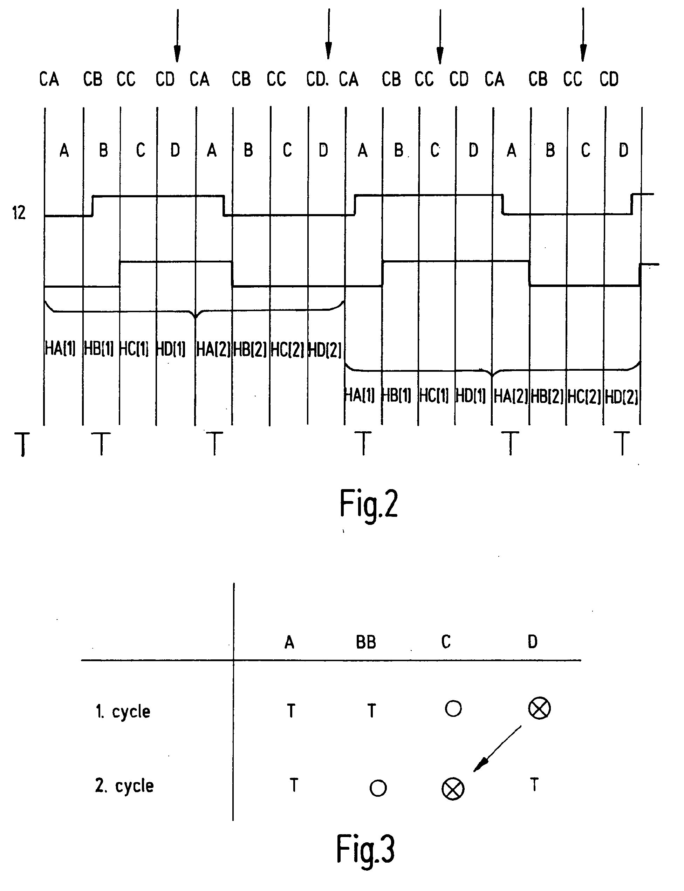

Fig. 2 shows the output signal 12 from the DUT 14 and below the corresponding over-sampled signal. On the top of the pulse graph the over-sampling clock edges CA, CB, CC, CD are shown. The fourfold over-sampled bit segments are repeatedly named A, B, C, D. During a first cycle represented by the left half of Figure 2, the content of the shift register 30 is HA[1], HB[1], HC[1], HD[1] and HA[2], HB[2], HC[2], HD[2]. In a subsequent second cycle represented by the right half of Figure 2, the content of the shift register 30 is shown in the lower line in Figure 2.

It is assumed that for the cycle previous the shown first cycle, the tap point to extract a bit value as being valid has been in bit segment D. During the first cycle signal transitions T occur in second bit segments B and A as being marked in the lowest line of Figure 2. Also during the first cycle, in first bit segments C and D no signal transitions occur as summarized in Fig. 3. Accordingly, the tap point has been kept in first bit segment D as being marked in the upper line of Figure 2 and the bit values "1" and "0" are extracted from the shift register 30 by the selecting unit 70. Further accordingly, no increment or decrement signal 52, 54 was transmitted from the phase correction unit 50 to the phase tracking counter 60. This behavior follows the strategy to select said first bit segment D being most distant from adjacent second bit segment B in which signal transition T occur. It is evident that it would be also possible to move the tap point to the first bit segment C or even to segment A, since the segment A has not yet seen the transition, though segment A is not the optimal selection for this example in view of the other possible bit segments.

During the second cycle signal transitions T occur in second bit segments A, A, and D. Therefore it is necessary to move tap point to first bit segment C by a corresponding decrement signal 54 from the phase correction unit 50 to the phase tracking counter unit 60. Accordingly, during the second cycle the bit values "1" and "0" are extracted out of the shift register 30 by the selecting unit 70.

The number of bit segments stored in the shift register 30 can be chosen according to the requirement how much of phase shift of the output signal 12 has to be tolerated by the inventive system. The more bit segments are stored in the shift register 30, the more phase shift can be tolerated.

The number of bits to be considered to detect transitions can be chosen according to the specific application or circumstances. The number of bits is at least one and as a maximum equal to the depth of the shift register 30. Assuming an over-sampling rate of four, if the number of bits is N, the possible tracking speed is one quarter of the bit period every N bits. A large number of bits reduces the need for frequent phase correction but also reduces the maximum possible tracking speed. In some applications, it might be advantageous to observe transitions in only a few number N of bits and to correct the phase less than every N bits for reducing the implementation efforts at the risk of missing some transitions.

The decision which bit segment is valid can be made based on hardware or software or on a combination of hardware and software.

The over-sampling rate is chosen according to the phase shift to be tolerated by the system. In general, a higher over-sampling rate allows a higher degree of jitter and drift tolerance. Odd numbers for the over-sampling rate are advantageous for providing a definite mid-point and balanced decisions. Even numbers for the over-sampling rate are advantageous for implementation constraints.

The selecting unit 70 or mux can either select one output at a time or can select several outputs at a time that changes less frequently. This is only an implementation choice having no impact on the capabilities of the inventive scheme.

The system according to the present invention is able to analyze the drift of the input signal 12 by the phase tracking counter unit 60. The control loop established by the phase correction unit 50 and the phase tracking counter unit 60 can be realized as a programmable digital filter to ideally emulate any clock data recovery frequency response.

## Claims

1. A method for recovering a bit stream in a signal (12), comprising the steps of:
• receiving said signal (12) as a received bit stream of known first bit rate,
• over-sampling said received signal (12) with a second bit rate, said second bit rate being n times higher than the first bit rate with n being at least three, said over-sampling resulting in an over-sampled bit stream wherein n bit segments (A,B,C,D) following each other forming a bit segment frame (24,26,28) and representing one bit of said received bit stream respectively,
• detecting signal transitions (T) in said over-sampled bit stream,
• selecting one of said first bit segments of each bit segment frame (24,26,28) respectively,
• extracting bit values from said selected first bit segments, and
• stringing together said extracted bit values as being said recovered bit stream (72).

2. The method of claim 1, **characterized by** selecting said first bit segment being most distant from adjacent second bit segments in which signal transitions (T) occur.

3. The method of claim 1 or any one of the above claims, wherein a number of said selected first bit segment within a corresponding bit segment frame (24,26,28) is kept for being also the number of said selected first bit segment of a bit segment frame (24,26,28) subsequent to said corresponding bit segment frame (24,26,28).

4. The method of claim 1 or any one of the above claims, wherein a number of said selected first bit segment within a corresponding bit segment frame (24,26,28) is incremented (52) or decremented (54) for being the number of said selected first bit segment of a bit segment frame (24,26,28) subsequent to said corresponding bit segment frame (24,26,28).

5. The method of claim 1 or any one of the above claims, wherein said electronic device (14) is an integrated electronic circuit and said signal (12) is a data response of said integrated electronic circuit on a test signal (16).

6. The method of claim 5, wherein said test signal (16) presets said first bit rate.

7. The method of claim 1 or any one of the above claims, further comprising the step of identifying first bit segments of said over-sampled bit stream in which no signal transitions (T) occur,

8. A method for testing an integrated electronic circuit, wherein said method for testing comprises said method for recovering of claim 1 or any of the above claims, and wherein said electronic device (14) being said integrated electronic circuit, **characterized by** comparing said recovered bit stream (72) with an expected bit stream and deciding automatically as a result of said comparison whether said integrated electronic circuit fulfills given specifications.

9. A software program or product, preferably stored on a data carrier, for executing the method of claim 1 or any of the above claims when running on a data processing system such as a computer.

10. A system for recovering a bit stream in a signal (12), comprising:
an over-sampling unit (20) for receiving said signal (12) as a received bit stream, and for over-sampling said received signal with a second bit rate, said second bit rate being n times higher than the first bit rate with n being at least three, said over-sampling resulting in an over-sampled bit stream wherein n bit segments (A,B,C,D) following each other forming a bit segment frame (24,26,28) and representing one bit of said received bit stream respectively,
an identifying unit (40) for identifying first bit segments of said over-sampled bit stream in which no signal transitions (T) occur,
a selecting unit (70) for selecting one of said first bit segments of each bit segment frame respectively,
an extracting unit (70) for extracting bit values from said selected first bit segments, and
a data string unit (70) for stringing together said extracted bit values as being said recovered bit stream.

11. The system of claim 10, **characterized in** comprising a shift register (30) for temporarily storing said over-sampled bit stream.

12. The system of claim 11 or any one of the above claims, further comprising a shift register (30) a detecting unit (40) for detecting signal transitions (T) in said over-sampled bit stream.
